# EUROPÄISCHE PATENTSCHRIFT

(11) **EP 1 277 240 B1**
(45) Veröffentlichungstag und Bekanntmachung des Hinweises auf die Patenterteilung: **20.05.2015**
(21) Anmeldenummer: 01931363.4
(22) Anmeldetag: 16.03.2001
(51) Int. Cl.: H01L 33/00

(54) **Verfahren zur Herstellung eines lichtmittierenden Halbleiterbauelements**
Method of manufacturing a light-emitting semiconductor element
Procédé de fabrication d'un composant semi-conducteur emetteur de lumière

(30) Priorität: 26.04.2000 DE 10020464; 26.05.2000 DE 10026255; 17.10.2000 DE 10051465
(43) Veröffentlichungstag der Anmeldung: 22.01.2003
(60) Teilanmeldung: 10180345.0
(73) Patentinhaber: OSRAM Opto Semiconductors GmbH, 93055 Regensburg (DE)
(72) Erfinder: BADER, Stefan, 93080 Pentling - Matting (DE); HAHN, Berthold, 93155 Hemau (DE); HÄRLE, Volker, 93164 Laaber (DE); LUGAUER, Hans-Jürgen, 93173 Wenzenbach (DE); MUNDBROD-VANGEROW, Manfred, 89312 Günzburg (DE); EISERT, Dominik, 93049 Regensburg (DE)
(74) Vertreter: Epping - Hermann - Fischer
(86) Internationale Anmeldenummer: PCT/DE2001/001002
(87) Internationale Veröffentlichungsnummer: WO 2001/082384

(56) Entgegenhaltungen:
- EP-A- 0 404 565
- EP-A- 0 740 376
- EP-A- 0 810 674
- EP-A- 0 871 228
- EP-A- 0 896 405
- EP-A- 0 905 797
- EP-A2- 0 926 744
- DE-A- 19 741 442
- DE-A- 19 830 838
- US-A- 5 157 468
- US-A- 5 661 074
- US-A- 5 780 873
- US-A- 5 786 606
- US-A- 5 862 167
- PATENT ABSTRACTS OF JAPAN vol. 1999, no. 08, 30. Juni 1999 (1999-06-30) & JP 11 068157 A (SUMITOMO ELECTRIC IND), 9. März 1999 (1999-03-09)
- PATENT ABSTRACTS OF JAPAN vol. 1996, no. 09, 30. September 1996 (1996-09-30) & JP 08 116090 A (ROHM CO LTD), 7. Mai 1996 (1996-05-07)

## Beschreibung

Die Erfindung bezieht sich auf ein Verfahren zur Herstellung eines strahlungsemittierenden Halbleiterbauelements nach dem Oberbegriff des Patentanspruchs 1.

Strahlungsemittierende Halbleiterbauelemente auf GaN-Basis sind beispielsweise bekannt aus US 5 210 051. Solche Halbleiterbauelemente enthalten einen Halbleiterkörper mit einer aktiven GaN-Schicht, die auf ein SiC-Substrat aufgebracht ist. Kontaktiert ist der Halbleiterkörper vorderseitig an der lichtauskoppelnden GaN-Schicht und rückseitig an dem SiC-Substrat.

Weiterhin ist beispielsweise aus US 5 874 747 bekannt, statt GaN verwandte Nitride sowie darauf basierende ternäre oder quaternäre Mischkristalle zu verwenden. Insbesondere fallen hierunter die Verbindungen AlN, InN, AlGaN, InGaN, InAlN und AlInGaN.

Im folgenden bezieht sich die Bezeichnung "III-V-Nitrid-Halbleiter" auf diese ternären und quaternären Mischkristalle sowie Galliumnitrid selbst.

Ferner ist bekannt, GaN-Halbleiterkristalle epitaktisch herzustellen. Als Substrat wird üblicherweise ein Saphirkristall oder SiC verwendet. Gemäß US 5 928 421 ist hinsichtlich der Vermeidung von Gitterfehlern ein SiC-Substrat vorzuziehen, da aufgrund der vergleichsweise großen Gitterfehlanpassung zwischen Saphir und GaN die auf Saphir aufgewachsenen GaN-Schichten eine hohe Anzahl von Gitterfehlern aufweisen.

Ein Nachteil von strahlungsemittierenden GaN-Halbleiterbauelementen besteht darin, daß an der Oberfläche, an der die im Halbleiterkörper erzeugte Strahlung ausgekoppelt wird, ein großer Brechungsindexsprung beim Übergang vom Halbleiterkörper zur Umgebung auftritt. Ein großer Brechungsindexsprung führt dazu, daß ein erheblicher Teil der Strahlung wieder in den Halbleiterkörper zurückreflektiert wird und dadurch die Strahlungsausbeute des Bauelements gemindert wird.

Eine Ursache hierfür liegt in der Totalreflexion der erzeugten Strahlung an der Auskoppelfläche. Lichtstrahlen werden vollständig in den Halbleiterkörper zurückreflektiert, falls der Einfallswinkel der Lichtstrahlen auf die Auskoppelfläche größer ist als der Totalreflexionswinkel, bezogen jeweils auf die Oberflächennormale. Mit steigendem Unterschied zwischen dem Brechungsindex des Halbleiterkörpers und der Umgebung sinkt der Totalreflexionswinkel und der Anteil der totalreflektierten Strahlung steigt.

Außerdem werden auch Lichtstrahlen, deren Einfallswinkel kleiner ist als der Totalreflexionswinkel, teilweise in den Halbleiterkörper zurückreflektiert, wobei der zurückreflektierte Anteil um so größer ist, je größer der Brechungsindexunterschied zwischen Halbleiterkörper und Umgebung ist. Ein großer Brechungsindexsprung, wie er bei GaN-Bauelementen auftritt, führt daher zu großen Reflexionsverlusten an der Auskoppelfläche. Die zurückreflektierte Srahlung wird teilweise im Halbleiterkörper absorbiert oder tritt an einer anderen Fläche als der Auskoppelfläche aus, so daß insgesamt die Strahlungsausbeute reduziert wird.

Ein Mittel, die Strahlungsausbeute zu erhöhen, besteht darin, auf das Substrat des Halbleiterkörpers einen Reflektor aufzubringen. Dies ist beispielsweise in DE 43 05 296 gezeigt. Dadurch wird die in den Halbleiterkörper zurückreflektierte Strahlung wiederum in Richtung der Auskoppelfläche gerichtet, so daß der zurückreflektierte Teil der Strahlung nicht verlorengeht, sondern zumindest teilweise nach einer oder mehreren internen Reflexionen ebenfalls ausgekoppelt wird.

Bei strahlungsemittierenden GaN-Bauelementen nach dem Stand der Technik ist es in dieser Hinsicht von Nachteil, ein absorbierendes Substrat wie beispielsweise SiC zu verwenden. Die in den Halbleiterkörper zurückreflektierte Strahlung wird vom Substrat großteils absorbiert, so daß eine Erhöhung der Strahlungsausbeute mittels eines Reflektors nicht möglich ist.

Aus der Patentschrift US 5,786,606 ist ein Herstellungsverfahren für strahlungsemittierende Halbleiterbauelemente auf GaN-Basis bekannt, bei dem auf einem SIMOX-Substrat (Separation by IMplantation of ÖXygen) oder einem SOI-Substrat (Silicon On Isolator) zunächst eine SiC-Schicht epitaktisch aufgewachsen wird. Auf dieser SiC-Schicht wird danach eine Mehrzahl von GaN-basierenden Schichten abgeschieden.

Durch die SiC-Schicht wird jedoch die Strahlungsausbeute des Bauelements reduziert, da in der SiC-Schicht ein Teil der erzeugten Strahlung absorbiert wird. Weiterhin erfordert auch die epitaktische Ausbildung einer SiC-Schicht mit ausreichender Kristallqualität einen hohen Herstellungsaufwand.

Der vorliegenden Erfindung liegt die Aufgabe zugrunde, ein Verfahren zur Herstellung Halbleiterbauelemente mit erhöhter Lichtausbeute zu entwickeln.

Diese Aufgabe wird durch ein Herstellungsverfahren nach Anspruch 1 gelöst.

Die Unteransprüche 2 bis 24 geben vorteilhafte Ausführungsformen des Herstellungsverfahrens nach Anspruch 1 an.

Bei dem erfindungsgemäßen Herstellungsverfahren wird zunächst auf ein Substrat eine Zwischenschicht aufgebracht. Auf dieser Zwischenschicht wird eine Mehrzahl unterschiedlicher III-V-Nitrid-Halbleiterschichten epitaktisch abgeschieden. Diese Schichten bilden den Halbleiterkörper des Bauelements. Im nächsten Schritt wird von dem so gebildeten Stapel von III-V-Nitrid-Schichten das Substrat einschließlich der Zwischenschicht abgelöst. In einem weiteren Schritt wird auf eine der beiden Hautflächen des Halbleiterkörpers ein Reflektor aufgebracht.

Bei einer weiteren Ausführungsform wird ein Si-Substrat verwendet, auf das eine SiC-Zwischenschicht aufgebracht ist. SiC eignet sich besonders für die Herstellung von GaN-basierten-Bauelementen, da es eine ähnliche Gitterkonstante wie GaN besitzt, so daß auf SiC abgeschiedene Schichten auf GaN-Basis eine geringe Zahl von Gitterfehlern aufweisen.

Die Zwischenschicht wird mittels eines Waferbonding-Verfahrens aufgebracht und danach abgedünnt. Bei der Verwendung eines Si-Substrats und einer SiC-Zwischenschicht kann vorteilhafterweise der Si-Wafer mit dem SiC-Wafer durch Ausbildung einer SiO₂-Schicht verbunden werden.

Bei einer weiteren bevorzugten Ausführungsform wird der Reflektor durch Aufbringung eines spiegelnden Metallkontakts auf den GaN-Halbleiterkörper ausgebildet. Als Materialien für den Metallkontakt eignen sich aufgrund ihrer Reflektivität sowie ihrer Bond-Eigenschaften besonders Ag und Al sowie Ag- und Al-Legierungen.

Eine weiteren Ausführungsform des Herstellungsverfahrens besteht darin, den Reflektor als dielektrischen Spiegel in Form einer Mehrzahl von dielektrischen Schichten auszubilden, woraus sich die oben beschriebenen Vorteile eines dielektrischen Reflektors ergeben.

In einer besonders bevorzugten Weiterbildung der Erfindung wird das Herstellungsverfahren fortgeführt durch eine Aufrauhung des Halbleiterkörpers, wobei die gesamte freie Oberfläche des Halbleiterkörpers oder Teilbereiche hiervon aufgerauht werden. Eine bezüglich der Erhöhung der Lichtausbeute besonders effektiver Aufrauhung wird durch Anätzen des Halbleiterkörpers oder mittels eines Sandstrahlverfahrens hergestellt.

Bei einer weiteren besonders bevorzugten Ausführungsform wird vor dem.Abscheiden der III-V-Nitrid-Schichten auf der Zwischenschicht eine Maskenschicht aufgebracht. Diese Maskenschicht strukturiert die Schichten und teilt insbesondere die III-V-Nitrid-Schichten in mehrere, nicht zusammenhängende Bereiche. Dies verhindert mit großem Vorteil Rißbildung und Ablösung der Zwischenschicht vom Substrat. Vorteilhafterweise wird - insbesondere bei Verwendung von SiC als Zwischenschichtmaterial - als Maske eine Oxidmaske ausgebildet.

Bei dem erfindungsgemäßen Herstellungsverfahren wird eine Mehrzahl von III-V-Nitrid-Schichten epitaktisch auf ein Verbundsubstrat aufgebracht, das einen Substratkörper und eine Zwischenschicht aufweist, wobei der thermische Ausdehnungskoeffizient des Substratkörpers größer ist als der thermische Ausdehnungskoeffizient der III-V-Nitrid-Schichten. Unter einem Verbundsubstrat ist hierbei ein Substrat zu verstehen, das mindestens zwei Bereiche, den Substratkörper und die Zwischenschicht, enthält und als solches das Ausgangssubstrat für das Epitaxieverfahren darstellt. Die Zwischenschicht ist nicht epitaktisch auf den Substratkörper aufgebracht, sondern durch ein Waferbonding-Verfahren.

Bei einem solchen Verbundsubstrat sind die thermischen Eigenschaften vor allem durch den Substratkörper bestimmt, während davon weitgehend unabhängig die Epitaxieoberfläche und insbesondere deren Gitterkonstante durch die Zwischenschicht festgelegt ist. Somit kann mit Vorteil die Zwischenschicht optimal an die Gitterkonstante der aufzubringenden Schichten angepaßt werden. Zugleich wird durch die Verwendung eines Substratkörpers mit einem ausreichend hohen thermischen Ausdehnungskoeffizienten verhindert, daß nach der Aufbringung der GaN-basierenden Schichten diese in der Abkühlphase zugverspannt werden und sich dadurch Risse in den Schichten bilden. Die Zwischenschicht wird so dünn ausgebildet, daß der thermische Ausdehnungskoeffizient des gesamten Verbundsubstrats im wesentlichen dem Ausdehnungskoeffizienten des Substratkörpers entspricht. Dabei ist der Substratkörper mindestens zwanzigmal dicker als die Zwischenschicht.

Bei einer vorteilhaften Ausgestaltung der Erfindung enthält der Substratkörper SiC, vorzugsweise polykristallin (Poly-SiC), Saphir, GaN oder AlN. Der thermische Ausdehnungskoeffizient von SiC ist ähnlich dem Ausdehnunskoeffizienten von GaN-basierenden Materialien, die übrigen genannten Materialien weisen einen größeren thermischen Ausdehnungskoeffizienten als GaN-basierende Materialien auf. Damit wird mit Vorteil eine Rissbildung bei der Abkühlung der epitaktisch aufgebrachten Schichten vermieden.

Bei einer bevorzugten Ausgestaltung der Erfindung enthält die Zwischenschicht SiC, Silizium, Saphir, oder MgO. Diese Materialien eignen sich insbesondere zur Ausbildung einer im wesentlichen monokristallinen Oberfläche mit einer an GaN angepaßten Gitterkonstante. Bevorzugt wird als Epitaxieoberfläche eine Si(111)-Oberfläche oder eine monokristalline SiC-Oberfläche verwendet, auf der die GaN-basierenden Schichten aufgewachsen werden.

Bei der Erfindung werden die GaN-basierenden Schichten auf einem Verbundsubstrat abgeschieden, bei dem die Zwischenschicht durch ein Waferbonding-Verfahren auf den Substratkörper aufgebracht ist. Zwischen Substratkörper und Zwischenschicht wird eine Haftschicht, beispielsweise aus Siliziumoxid, ausgebildet.

Mit Waferbonding-Verfahren kann mit Vorteil eine Vielzahl von Materialsystemen kombiniert werden, ohne durch Materialunverträglichkeiten, wie sie beispielsweise beim epitaktischen Aufbringen einer Zwischenschicht auf einen Substratkörper auftreten, limitiert zu sein.

Um eine ausreichend dünne Zwischenschicht zu erhalten, kann dabei auch zunächst eine dickere Zwischenschicht auf den Substratkörper aufgebondet werden, die dann, beispielsweise durch Schleifen oder Spalten, auf die erforderliche Dicke abgedünnt wird.

Bei einer vorteilhaften Weiterbildung der Erfindung wird vor der Abscheidung der III-V-Nitrid-Schichten auf dem Verbundsubstrat eine Maskenschicht ausgebildet, so daß nur auf den von der Maske unbedeckten Bereichen der Epitaxieoberfläche die III-V-Nitrid-Schichten aufwachsens. Dadurch werden mit Vorteil diese Schichten in der Schichtebene unterbrochen und so ein zusätzlicher Schutz gegen Zugverspannung und die damit einhergehende Rissbildung erreicht.

Eine weiter bevorzugte Ausgestaltung der Erfindung besteht darin, die III-V-Nitrid-Schichten nach der Abscheidung auf dem Verbundsubstrat in einzelne Halbleiterschichtstapel zu strukturieren. Danach wird auf die III-V-Nitrid-Halbleiterschichtstapel ein Träger aufgebracht und das Verbundsubstrat abgelöst. Das Verbundsubstrat kann so zumindest zu Teilen wiederverwendet werden. Dies stellt einen besonderen Vorteil bei SiC-Substratkörpern dar, deren Herstellung mit sehr hohen Kosten verbunden ist. Weiterhin wird auf diese Art und Weise ein Dünnschichtbauelement hergestellt. Unter einem Dünnschichtbauelement ist dabei ein Bauelement zu verstehen, das kein Epitaxiesubstrat enthält. Im Falle von strahlungsemittierenden Halbleiterbauelementen wird so eine Erhöhung der Strahlungsausbeute erzielt, da eine Absorption der erzeugten Strahlung im Epitaxiesubstrat, wie sie insbesondere bei SiC-Substraten auftritt, vermieden wird.

Das eben beschriebene sogenannte Umbonden der Halbleiterschichtstapel von dem Verbundsubstrat auf einen Träger kann bei der Erfindung auch in zwei Schritten erfolgen, wobei die GaN-basierenden Halbleiterschichtstapel zunächst auf einen Zwischenträger und dann auf den eigentlichen Träger gebondet werden, so daß abschließend der eigentliche Träger an die Stelle des Verbundsubstrats tritt. Mit Vorteil weisen so hergestellte Halbleiterschichtstapel eine entsprechende Schichtenfolge wie GaN-basierendes Halbleiterkörper mit Epitaxiesubstrat nach dem Stand der Technik auf, so daß für beide Schichtstapel dieselben nachfolgenden Verarbeitungsschritte wie beispielsweise Vereinzeln, Kontaktieren und Einbau in ein Gehäuse herangezogen werden können.

Bei dem Herstellungsverfahren wird auf dem Halbleiterschichtstapel zur Steigerung der Strahlungsausbeute eine Reflektorschicht ausgebildet. Die Strahlungsausbeute bei GaN-basierenden Halbleiterbauelementen wird aufgrund des hohen Brechungsindex von GaN-basierenden Materialien zum Großteil durch Reflexion an den Grenzflächen des Halbleiterkörpers begrenzt. Bei strahlungsemittierenden Halbleiterkörpern ohne absorbierendem Substrat können mit Vorteil durch eine Reflektorschicht die an der Auskoppelfläche reflektierten Strahlungsanteile wiederum auf die Auskoppelfläche zurückgerichtet werden. Damit wird die Strahlungsausbeute weiter erhöht.

Vorzugsweise wird die Reflektorschicht als Metallschicht, die beispielsweise Aluminium, Silber oder eine entsprechende Aluminium- oder Silberlegierung enthält, ausgebildet.

Mit Vorteil kann eine solche Metallschicht zugleich als Kontaktfläche verwendet werden. Alternativ kann die Reflektorschicht auch durch eine dielektrische Verspiegelung in Form einer Mehrzahl von dielektrischen Schichten ausgebildet werden.

Bei einer vorteilhaften Weiterbildung der Erfindung wird zumindest eine Teil der Oberfläche des Halbleiterschichtstapels aufgerauht. Dadurch wird eine Totalreflexion an der Oberfläche gestört und so eine Erhöhung der Strahlungsausbeute erzielt. Vorzugsweise erfolgt die Aufrauhung durch Ätzen oder ein Sandstrahlverfahren.

Weitere Merkmale, Vorteile und Zweckmäßigkeiten ergeben sich aus der nachfolgenden Beschreibung von vier Ausführungsbeispielen in Verbindung mit den Figuren 1 bis 7. Es zeigen:
- Figur 1: eine schematische Schnittansicht eines ersten Halbleiterbauelements,
- Figur 2: eine schematische Schnittansicht eines zweiten Halbleiterbauelements,
- Figur 3: eine schematische Darstellung eines ersten Ausführungsbeispiels eines erfindungsgemäßen Herstellungsverfahrens und
- Figur 4: eine schematische Darstellung eines zweiten Ausführungsbeispiels eines erfindungsgemäßen Herstellungsverfahrens.
- Figur 5: eine schematische Schnittdarstellung eines weiteren Ausführungsbeispiels eines erfindungsgemäßen Herstellungsverfahrens,
- Figur 6: eine schematische Schnittdarstellung eines weiteren Ausführungsbeispiels eines erfindungsgemäßen Herstellungsverfahrens und
- Figur 7: eine schematische Schnittdarstellung eines weiteren Ausführungsbeispiels eines erfindungsgemäßen Herstellungsverfahrens.

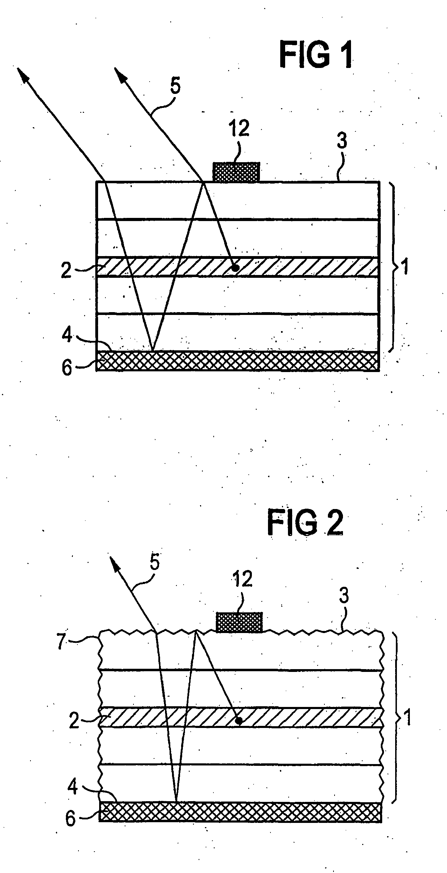

Das in Figur 1 dargestellte strahlungsemittierende Halbleiterbauelement weist eine Mehrzahl von stapelförmig angeordneten, unterschiedlichen Halbleiterschichten 1 auf, die aus GaN oder einer darauf basierenden ternären oder quaternären Verbindung bestehen. Im Betrieb bildet sich innerhalb dieser Schichten eine aktive Zone 2 aus, in der die Strahlung 5 generiert wird.

Der Schichtstapel wird von einer ersten Hauptfläche 3 und einer zweiten Hauptfläche 4 begrenzt. Im wesentlichen wird die erzeugte Strahlung 5 durch die erste Hauptfläche 3 in die angrenzende Umgebung ausgekoppelt.

Auf der zweiten Hauptfläche 4 ist ein Reflektor 6 aufgebracht, gebildet von einer direkt auf den Halbleiterkörper aufgedampften Ag-Schicht. Kontaktiert wird der Halbleiterkörper auf der Auskopplungsseite über die Kontaktfläche 12 sowie reflektorseitig über die Ag-Reflektorschicht. Die reflektorseitige Kontaktierung kann beispielsweise dadurch erfolgen, daß der Halbleiterkörper reflektorseitig auf einen Metallkörper aufgesetzt ist, der sowohl als Träger wie auch der Stromzuführung dient.

Der Reflektor 6 bewirkt, daß ein Teil der Strahlung 5, die bei der Auskopplung an der ersten Hauptfläche 3 in den Halbleiterkörper zurückreflektiert wird, wiederum in Richtung der ersten Hauptfläche 3 reflektiert wird, so daß insgesamt die durch die erste Hauptfläche 3 ausgekoppelte Strahlungsmenge erhöht wird. Diese Erhöhung wird dadurch ermöglicht, daß das Bauelement als Dünnschichtbauelement ohne stahlungsabsorbierendes Substrat ausgeführt ist und der Reflektor 6 direkt auf dem GaN-Halbleiterkörper aufgebracht ist.

Das in Figur 2 dargestellte Halbleiterbauelement unterscheidet sich von dem in Figur 1 gezeigten Bauelement darin, daß die Oberfläche des Halbleiterkörpers eine Aufrauhung 7 aufweist. Diese Aufrauhung 7 bewirkt eine Streuung der Strahlung 5 an der ersten Hauptfläche 3, so daß die Totalreflexion an der ernsten Hauptfläche 3 gestört wird. Weitergehend verhindert diese Streuung, daß die erzeugte Strahlung durch fortlaufende, gleichartige Reflexionen zwischen den beiden Hauptflächen 3 und 4 bzw. dem Reflektor 6 nach Art eines Lichtleiters geführt wird, ohne den Halbleiterkörper zu verlassen. Somit wird durch die Aufrauhung 7 die Lichtausbeute weiter erhöht.

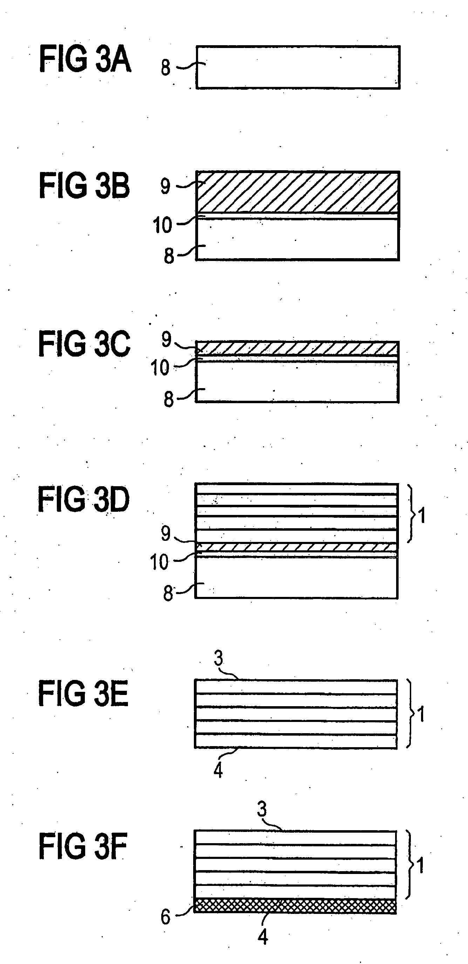

In Figur 3 ist ein erste Ausführungsbeispiel eines erfindungsgemäßen Herstellungsverfahrens gezeigt. Den Ausgangspunkt stellt ein Si-Substrat 8 dar, Fig. 3a. Auf dieses Si-Substrat wird in einem ersten Schritt eine SiC-Zwischenschicht 9 mittels eines Waferbonding-Verfahrens aufgebracht, wobei zwischen den beiden Substraten eine SiO₂-Schicht 10 ausgebildet wird, Fig. 3b. Im nächsten Schritt wird das SiC-Substrat 9 bis auf wenige Mikrometer abgedünnt, Fig. 3c. Auf dem abgedünnten SiC-Substrat 9 wird epitaktisch mittels eines MOCVD-Verfahrens eine Mehrzahl unterschiedlicher GaN-Halbleiterschichten 1 abgeschieden, die den Halbleiterkörper des erfindungsgemäßen Bauelements bilden, Fig. 3d. Nach der Herstellung des GaN-Schichtstapels wird das Si-Substrat 8 sowie die SiC-Zwischenschicht 9 entfernt, Fig. 3e. Danach wird auf eine Hauptfläche 4 des GaN-Halbleiterkörpers eine spiegelnde metallische Kontaktfläche 6, bestehend aus einer Ag- oder Al-Legierung, aufgedampft, Fig. 3f.

Um Totalreflexion an der ersten Hauptfläche 3 zu mindern, kann anschließend der Halbleiterkörper durch ein Sandstrahl verfahren oder durch Anätzen mit einer geeigneten Ätzmischung aufgerauht werden.

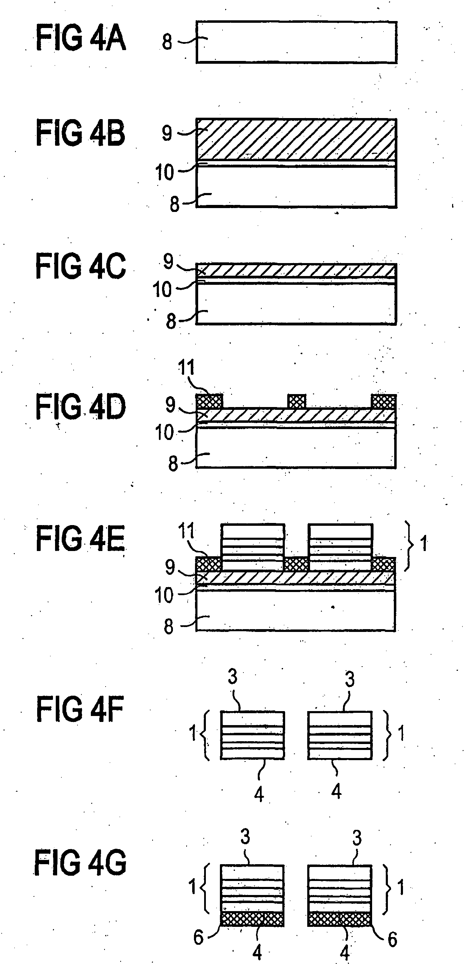

Die in Fig. 4 dargestellte Ausführungsform eines erfindungsgemäßen Herstellungsverfahrens verläuft bis einschließlich des Abdünnens des SiC-Substrats 9 (Fig. 4a bis Fig. 4c) analog zu dem oben beschriebenen ersten Ausführungsbeispiel. Im Unterschied dazu wird vor dem Abscheiden der GaN-Schichten 1 eine Oxidmaske 11 auf die SiC-Schicht 9 aufgebracht, Fig. 4d. Diese Oxidmaske 11 bewirkt, daß im nächsten Schritt die GaN-Schichten 1 nur auf den von der Maske nicht bedeckten Teilbereichen der SiC-Zwischenschicht aufwachsen.

Da die so gebildeten GaN-Schichten 1 entlang der Schichtebene unterbrochen sind, werden Verspannungen, die auf den unterschiedlichen thermischen Ausdehnungskoeffizienten von SiC und GaN beruhen und vor allem bei Abkühlen des Bauelements nach der Herstellung entstehen, vermindert. Dies führt vorteilhafterweise zu einer geringeren Rißbildung in den GaN-Schichten 1 und unterbindet eine Delamination der SiC-Zwischenschicht 9 vom Substrat. Die Herstellung des Reflektors 6, Fig. 4g, erfolgt wie oben beschrieben.

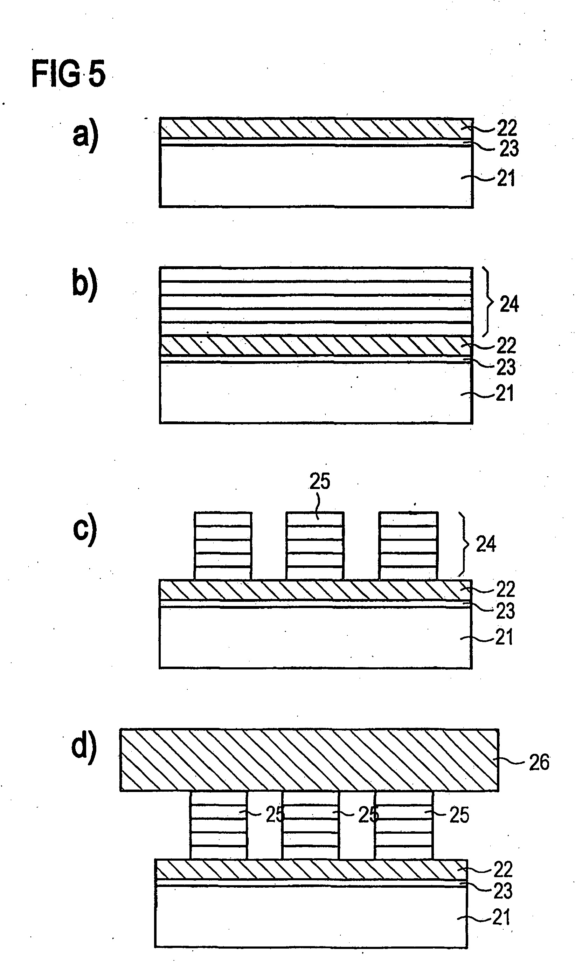

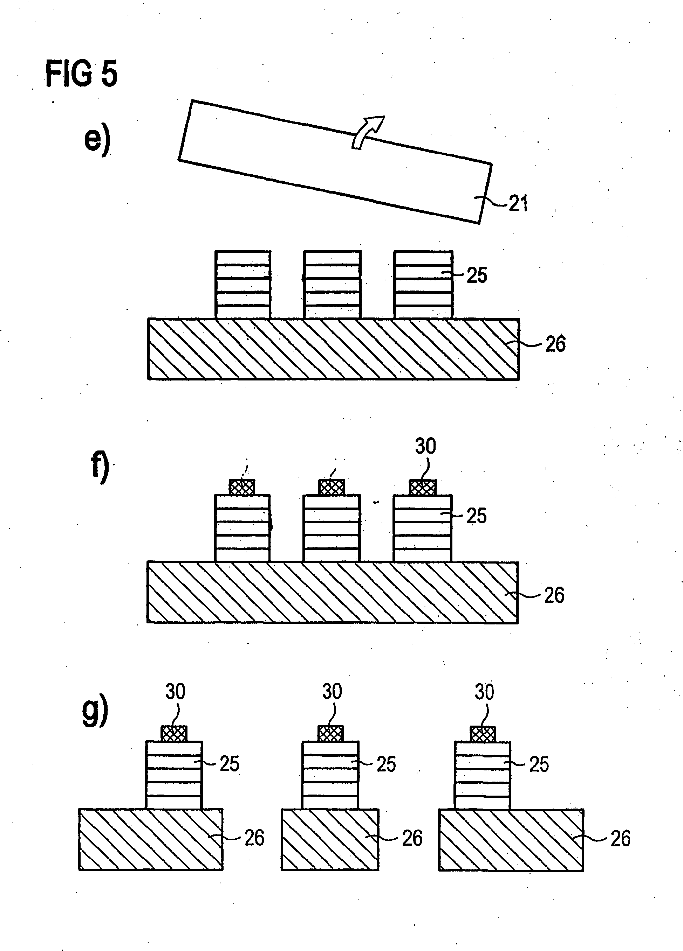

Bei dem in Figur 5 dargestellten Herstellungsverfahren wird ein Verbundsubstrat mit einem Substratkörper 21 aus Poly-SiC verwendet, auf den in bekannter Weise eine monokristalline SiC-Zwischenschicht 22 aufgebondet ist. Hierzu ist zwischen dem Substratkörper 21 und der Zwischenschicht 22 eine Haftschicht 23, beispielsweise aus Siliziumoxid, ausgebildet, Figur 5a.

Auf dieses Verbundsubstrat wird epitaktisch eine Mehrzahl von GaN-basierenden Schichten 24 aufgewachsen, Figur 5b. Die Struktur der Schichtenfolge ist keinen prinzipiellen Beschränkungen unterworfen.

Vorzugsweise wird hierbei eine aktive, der Strahlungserzeugung dienende Schicht ausgebildet, die von einer oder mehreren Mantelschichten und/oder Wellenleiterschichten umgeben ist.

Die aktive Schicht kann dabei durch eine Mehrzahl von dünnen Einzelschichten in Form einer Einfach- oder Mehrfachquantentopfstruktur ausgebildet sein.

Weiterhin ist es vorteilhaft, auf der Zwischenschicht 22 zunächst eine Pufferschicht, beispielsweise auf AlGaN-Basis, auszubilden, durch die eine verbesserte Gitteranpassung und eine höhere Benetzbarkeit hinsichtlich der folgenden Schichten erreicht werden kann. Um die elektrische Leitfähigkeit einer solchen Pufferschicht zu erhöhen, können in die Pufferschicht elektrisch leitfähige Kanäle, beispielsweise auf InGaN-Basis, eingeschlossen werden.

Anschließend werden die GaN-basierenden Schichten 24 durch eine laterale Strukturierung, vorzugsweise durch eine Mesa-Ätzung, in einzelne Halbleiterschichtstapel 25 unterteilt, Figur 5c.

Auf diese Halbleiterschichtstapel 25 wird im nächsten Schritt, Figur 5d, ein Träger 26, beispielsweise aus GaAs oder einem für die erzeugte Strahlung durchlässigen Material, aufgebracht.

Daraufhin wird das Verbundsubstrat einschließlich der Zwischenschicht 22 von den Halbleiterschichtstapeln 25 abgelöst, Figur 5e. Dies kann beispielsweise durch ein Ätzverfahren erfolgen, bei dem die Zwischenschicht 22 oder die Haftschicht 23 zerstört wird. Mit Vorteil kann der Substratkörper 21 in einem weiteren Herstellungszyklus wiederverwendet werden.

Nachfolgend werden auf die so gebildeten Dünnschichthalbleiterkörper 25 Kontaktflächen 30 aufgebracht, Figur 5f. Abschließend werden die Halbleiterschichtstapel 25 vereinzelt, Figur 5g, und in üblicher Weise weiterverarbeitet.

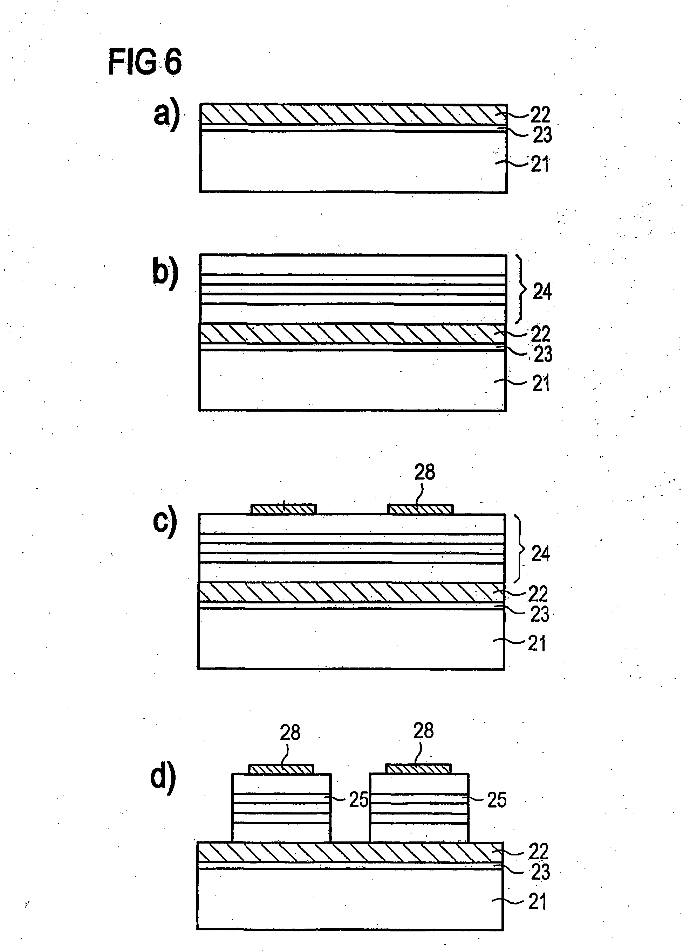

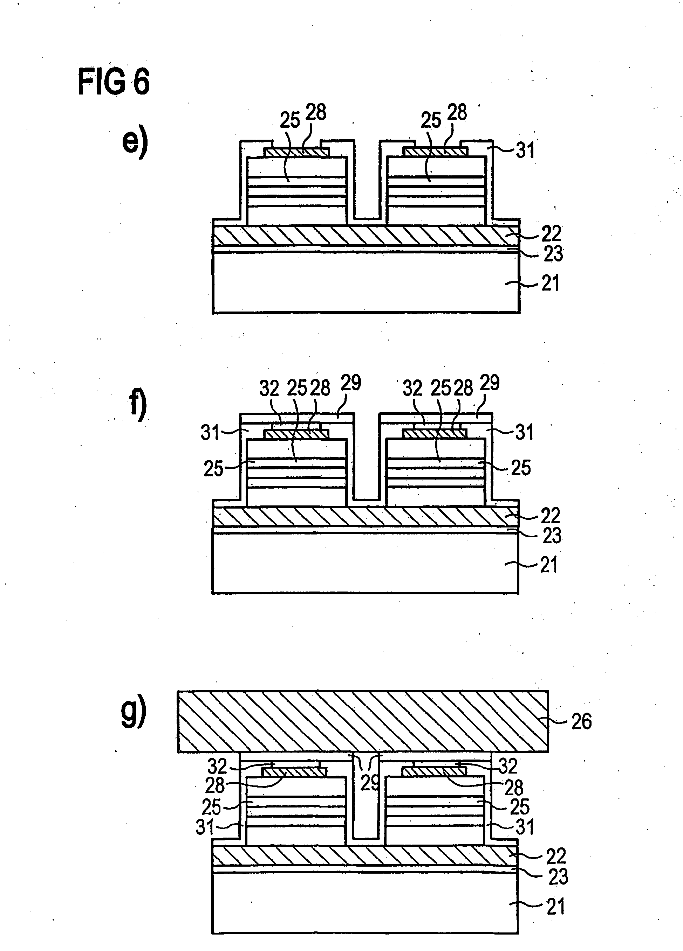

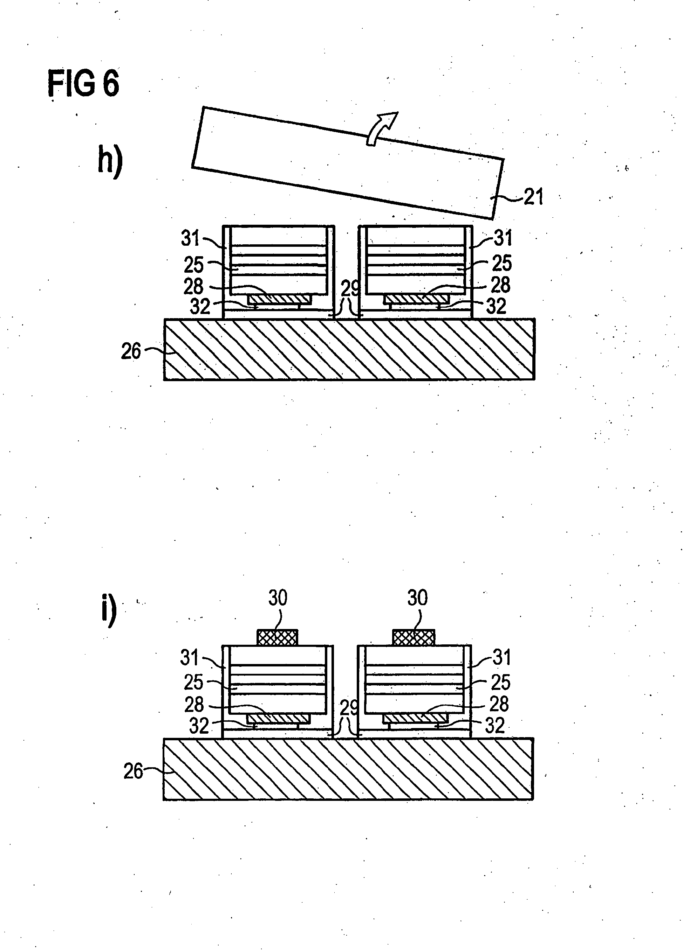

Bei dem in Figur 6 dargestellten Herstellungsverfahren wird wiederum ein Verbundsubstrat verwendet, das im wesentlichen von einem Poly-SiC-Substratkörper 21 und einer Si(111)-Zwischenschicht 22 gebildet wird. Die Zwischenschicht 22 ist mit Hilfe eines Wäferbonding-Verfahrens auf den Substratkörper 21 unter Ausbildung einer Siliziumoxid-Haftschicht 23 aufgebracht, Figur 6a.

Auf dieses Verbundsubstrat wird wiederum eine Mehrzahl von GaN-basierenden Schichten aufgewachsen, Figur 6b, die abschließend mit einer Kontaktschicht 28, beispielsweise aus Platin, versehen wird, Figur 6c.

Nachfolgend werden die GaN-basierenden Schichten 24 durch eine Ätzstrukturierung in einzelne Halbleiterschichtstapel 25 unterteilt, Figur 6d.

Auf diese so gebildeten Halbleiterschichtstapel 25 wird zum Schutz eine Passivierungsschicht 31, vorzugsweise auf Siliziumnitrid-Basis, aufgebracht, Figur 6e.

Auf den nicht von der Passivierungsschicht bedeckten Bereichen der Kontaktschicht 28 wird nun jeweils ein Bondlot 32 und darauf ein Reflektor 29 aus einer Silber- oder Aluminiumlegierung abgeschieden, Figur 6f.

Anschließend werden die Halbleiterschichtstapel 25 mit dem Reflektor 29 eutektisch auf einen Träger 26 umgebondet, Figur 6g.

Im nachfolgenden Schritt, Figur 6h, wird der Substratkörper 21 entfernt und kann so wiederverwendet werden.

Abschließend werden die einzelnen Halbleiterschichtstapel oberseitig mit Kontaktflächen 30 versehen, Figur 6i. Nachfolgend können die Halbleiterschichtstapel vereinzelt und gegebenenfalls in ein Gehäuse eingebaut werden (nicht dargestellt).

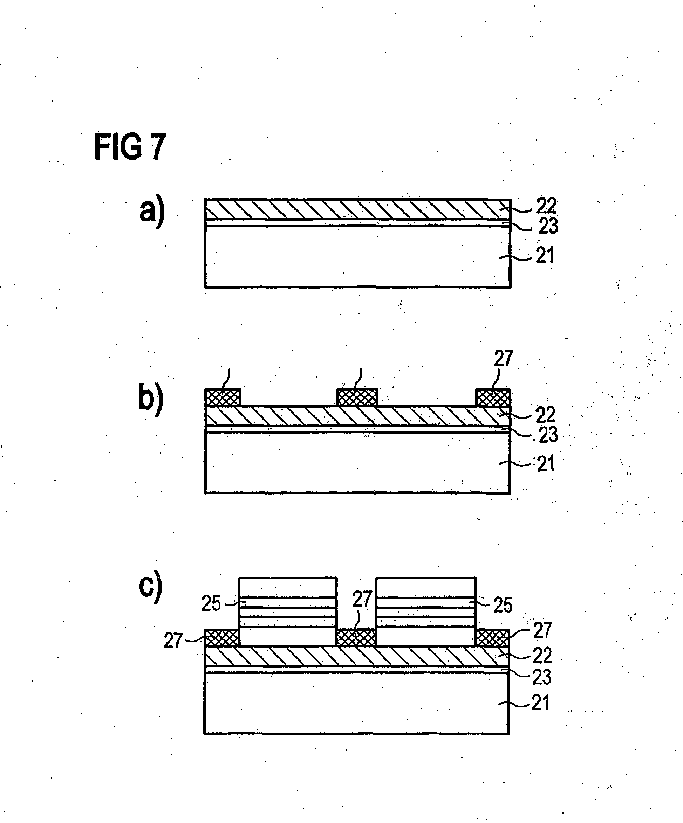

Das in Figur 7 dargestellt Ausführungsbeispiel eines erfindungsgemäßen Herstellungsverfahrens stellt eine Variante der vorigen Ausführungsbeispiele dar.

Wiederum wird, wie bereits beschrieben, als Epitaxiesubstrat ein Verbundsubstrat verwendet, Figur 7a.

Vor der Abscheidung der GaN-basierenden Schichten 24 wird auf die Epitaxieoberfläche der Zwischenschicht 22 eine Maskenschicht 27 aufgebracht, Figur 7b. Die GaN-basierenden Schichten 24 wachsen so nur auf den Bereichen der Epitaxieoberfläche auf, die von der Maskenschicht 27 nicht bedeckt sind (Epitaxiefenster), Figur 7c. Dadurch werden die GaN-basierenden Schichten 24 in Richtung der Schichtebene unterbrochen. So wird zusätzlich eine Zugverspannung in den eptiaktisch abgeschiedenen Schichten in der Abkühlphase vermieden.

Nachfolgend kann das Herstellungsverfahren wie in den anderen Ausführungsbeipielen fortgesetzt werden.

Die Erläuterung der Erfindung anhand der beschriebenen Ausführungsbeispiele ist selbstverständlich nicht als Beschränkung der Erfindung hierauf zu verstehen.

## Patentansprüche

1. Verfahren zur Herstellung eines strahlungsemittierenden Halbleiterbauelements, dessen Halbleiterkörper durch einen Stapel unterschiedlicher III-V-Nitrid-Halbleiterschichten (1) gebildet ist und der eine erste Hauptfläche (3) und eine zweite Hauptfläche (4) aufweist, wobei wenigstens ein Teil der erzeugten Strahlung (5) durch die erste Hauptfläche (3) ausgekoppelt wird und die zweite Hauptfläche (4) einen Reflektor (6) aufweist,
mit den Schritten
- Aufbringen einer Zwischenschicht (9), die SiC, Silizium, Saphir oder MgO enthält, auf einen Substratkörper (8), zum Bilden eines Verbundsübstrats
- epitaktisches Aufbringen einer Mehrzahl unterschiedlicher III-V-Nitrid-Haltleiterschichten (1) auf die Zwischenschicht (9)
- Ablösen des Substratkörpers (8) einschließlich der Zwischenschicht (9)
- Aufbringen des Reflektors (6) auf die zweite Hauptfläche (4) des Halbleiterkörpers, wobei
- der thermische Ausdehnungskoeffizient des Substratkörpers größer ist als der thermische Ausdehnungskoeffizient der III-V-Nitrid-Schichten,
- zwischen Substratkörper und Zwischenschicht eine Haftschicht ausgebildet ist,
- der Substratkörpers (8) mindestens zwanzigmal dicker als die Zwischenschicht (9) ist, und
- die Zwischenschicht (9) durch ein Waferbonding-Verfahren aufgebracht wird.

2. Verfahren nach Anspruch 1,
**dadurch gekennzeichnet, daß**
als Zwischenschicht eine SiC-Zwischenschicht aufgebracht wird und als Substratkörper (8) ein Si-Substrat verwendet wird.

3. Verfahren nach Anspruch 1,
**dadurch gekennzeichnet, daß**
als Zwischenschicht eine SiC-Zwischenschicht aufgebracht wird.

4. Verfahren nach einem der Ansprüche 1 bis 3,
**dadurch gekennzeichnet, daß**
der Reflektor (6) durch Aufbringen einer Metallschicht gebildet wird, die zugleich der Kontaktierung des Halbleiterkörpers dient.

5. Verfahren nach einem der Ansprüche 1 bis 4,
**dadurch gekennzeichnet, daß**
vor Herstellung der GaN-Schichten (1) auf die Zwischenschicht (9) eine Maske (11) aufgebracht wird.

6. Verfahren nach einem der Ansprüche 1 bis 5,
**dadurch gekennzeichnet, daß**
der Halbleiterkörper aufgerauht wird.

7. Verfahren nach Anspruch 6,
**dadurch gekennzeichnet, daß**
der Halbleiterkörper durch Ätzen aufgerauht wird.

8. Verfahren nach Anspruch 6,
**dadurch gekennzeichnet, daß**
der Halbleiterkörper durch ein Sandstrählverfahren aufgerauht wird.

9. Verfahren nach Anspruch 1 oder 8,
**dadurch gekennzeichnet, daß**
der Substratkörper SiC, Poly-SiC, Saphir, GaN oder AlN enthält.

10. Verfahren nach einem der Ansprüche 1 oder 9,
**dadurch gekennzeichne**t, daß
die Zwischenschicht zumindest in Teilbereichen eine monokristalline Oberfläche aufweist.

11. Verfahren nach einem der Ansprüche 1 oder 9 bis 10,
**dadurch gekennzeichnet, daß**
die III-V-Nitrid-Schichten auf einer Si(111)-Oberfläche oder einer zumindest in Teilbereichen monokristallinen SiC-Oberfläche der Zwischenschicht abgeschieden werden.

12. Verfahren nach Anspruch 1,
**dadurch gekennzeichnet, daß**
die Haftschicht Siliziumoxid enthält.

13. Verfahren nach einem der Ansprüche 1 oder 9 bis 12,
**dadurch gekennzeichnet, daß**
vor dem Aufbringen der III-V-Nitrid-Schichten auf dem Verbundsubstrat eine Maskenschicht mit Epitaxiefenstern ausgebildet wird, wobei die Epitaxieoberfläche des Verbundsubstrats innerhalb der Epitaxiefenster unbedeckt bleibt.

14. Verfahren nach einem der Ansprüche 1 oder 9 bis 13,
**dadurch gekennzeichnet, daß**
die III-V-Nitrid-Schichten nach der Aufbringung auf das Verbuncisubstrat in einzelne Halbleiterschichtstapel strukturiert werden.

15. Verfahren nach Anspruch 14,
**dadurch gekennzeichnet, daß**
das Verfahren fortgesetzt wird mit den Schritten:
- Aufbringen eines Trägers auf die Halbleiterschichtstapel,
- Ablösen des Verbundsubstrats.

16. Verfahren nach Anspruch 14,
**dadurch gekennzeichnet, daß**
das Verfahren fortgesetzt wird mit den Schritten:
- Aufbringen eines Zwischenträgers auf die Halbleiterschichtstapel,
- Ablösen des Verbundsubstrats,
- Aufbringen eines Trägers auf der Seite der Halbleiterschichtstapel, von der das Verbundsubstrat abgelöst wurde,
- Ablösen des Zwischenträgers.

17. Verfahren nach Anspruch einem der Ansprüche 1 oder 9 bis 15,
**dadurch gekennzeichnet, daß**
die Reflektorschicht durch Aufbringen einer Metallschicht gebildet wird.

18. Verfahren nach Anspruch 17,
**dadurch gekennzeichnet, daß**
die Metallschicht Silber, Aluminium oder eine Silber- oder Aluminiumlegierung enthält.

19. Verfahren nach einem der Ansprüche 17 und 18,
**dadurch gekennzeichnet, daß**
die Reflektorschicht zugleich als Kontaktfläche dient.

20. Verfahren nach einem der Ansprüche 1 oder 9 bis 16,
**dadurch gekennzeichnet, daß**
die Reflektorschicht durch eine dielektrische Verspiegelung gebildet wird.

21. Verfahren nach einem der Ansprüche 1 oder 9 bis 16,
**dadurch gekennzeichnet, daß**
die Reflektorschicht durch Aufbringen einer transparenten ersten Schicht auf den Halbleiterschichtstapeln und Aufbringen einer spiegelnden zweiten Schicht auf der ersten Schicht gebildet wird.

22. Verfahren nach einem der Ansprüche 14 bis 21,
**dadurch gekennzeichnet, daß**
die Oberfläche der Halbleiterschichtstapel zumindest bereichsweise aufgerauht wird.

23. Verfahren nach Anspruch 22,
**dadurch gekehnzeichnet,** daß
die Oberfläche der Halbleiterschichtstapel durch Ätzen aufgerauht wird.

24. Verfahren nach Anspruch 22,
**dadurch gekennzeichnet, daß**
die Oberfläche der Halbleiterschichtstapel durch ein Sandstrahlverfahren aufgerauht wird.

## Claims

1. Method for producing a radiation-emitting semiconductor component, the semiconductor body of which is formed by a stack of different III-V nitride semiconductor layers (1) and which has a first main surface (3) and a second main surface (4), wherein at least part of the generated radiation (5) is coupled out through the first main surface (3) and the second main surface (4) has a reflector (6),
comprising the following steps,
- applying an intermediate layer (9), which contains SiC, silicon, sapphire or MgO, to a substrate body (8), in order to form a composite substrate,
- epitaxially applying a plurality of different III-V nitride semiconductor layers (1) to the intermediate layer (9),
- stripping away the substrate body (8) including the intermediate layer (9),
- applying the reflector (6) to the second main surface (4) of the semiconductor body, wherein
- the coefficient of thermal expansion of the substrate body is greater than the coefficient of thermal expansion of the III-V nitride layers,
- an adhesion layer is formed between substrate body and intermediate layer,
- the substrate body (8) is at least twenty times thicker than the intermediate layer (9), and
- the intermediate layer (9) is applied by means of a wafer bonding method.

2. Method according to Claim 1,
**characterized in that**
an SiC intermediate layer is applied as the intermediate layer and an Si substrate is used as the substrate body (8).

3. Method according to Claim 1,
**characterized in that**
an SiC intermediate layer is applied as the intermediate layer.

4. Method according to any of Claims 1 to 3,
**characterized in that**
the reflector (6) is formed by applying a metal layer that simultaneously serves for making contact with the semiconductor body.

5. Method according to any of Claims 1 to 4,
**characterized in that**
a mask (11) is applied to the intermediate layer (9) before the GaN layers (1) are produced.

6. Method according to any of Claims 1 to 5,
**characterized in that**
the semiconductor body is roughened.

7. Method according to Claim 6,
**characterized in that**
the semiconductor body is roughened by etching.

8. Method according to Claim 6,
**characterized in that**
the semiconductor body is roughened by a sandblasting method.

9. Method according to Claim 1 or 8,
**characterized in that**
the substrate body contains SiC, poly-SiC, sapphire, GaN or AlN.

10. Method according to either of Claims 1 and 9,
**characterized in that**
the intermediate layer has a monocrystalline surface at least in partial regions.

11. Method according to any of Claims 1 or 9 to 10,
**characterized in that**
the III-V nitride layers are deposited on an Si(111) surface or an SiC surface of the intermediate layer that is monocrystalline at least in partial regions.

12. Method according to Claim 1,
**characterized in that**
the adhesion layer contains silicon oxide.

13. Method according to any of Claims 1 or 9 to 12,
**characterized in that**
a mask layer with epitaxy windows is formed prior to the application of the III-V nitride layers on the composite substrate, wherein the epitaxy surface of the composite substrate remains uncovered within the epitaxy windows.

14. Method according to any of Claims 1 or 9 to 13,
**characterized in that**
the III-V nitride layers are patterned into individual semiconductor layer stacks after the application to the composite substrate.

15. Method according to Claim 14,
**characterized in that**
the method is continued with the following steps:
- applying a carrier to the semiconductor layer stacks,
- stripping away the composite substrate.

16. Method according to Claim 14,
**characterized in that**
the method is continued with the following steps:
- applying an intermediate carrier to the semiconductor layer stacks,
- stripping away the composite substrate,
- applying a carrier on the side of the semiconductor layer stacks from which the composite substrate has been stripped away,
- stripping away the intermediate carrier.

17. Method according to any of Claims 1 or 9 to 15,
**characterized in that**
the reflector layer is formed by applying a metal layer.

18. Method according to Claim 17,
**characterized in that**
the metal layer contains silver, aluminium or a silver or aluminium alloy.

19. Method according to either of Claims 17 and 18,
**characterized in that**
the reflector layer simultaneously serves as a contact area.

20. Method according to any of Claims 1 or 9 to 16,
**characterized in that**
the reflector layer is formed by a dielectric reflective coating.

21. Method according to any of Claims 1 or 9 to 16,
**characterized in that**
the reflector layer is formed by applying a transparent first layer on the semiconductor layer stacks and applying a reflective second layer on the first layer.

22. Method according to any of Claims 14 to 21,
**characterized in that**
the surface of the semiconductor layer stacks is roughened at least in regions.

23. Method according to Claim 22,
**characterized in that**
the surface of the semiconductor layer stacks is roughened by etching.

24. Method according to Claim 22,
**characterized in that**
the surface of the semiconductor layer stacks is roughened by means of a sandblasting method.

## Revendications

1. Procédé pour la fabrication d'un composant semi-conducteur émettant un rayonnement, dont le corps semi-conducteur est constitué par un empilement de différentes couches (1) de semi-conducteurs aux nitrures de III-V et qui comporte une première surface principale (3) et une deuxième surface principale (4), au moins une partie du rayonnement (5) engendré étant découplée par la première surface principale (3) et la deuxième surface principale (4) comportant un réflecteur (6),
comportant les étapes
- application d'une couche intermédiaire (9), qui contient SiC, du silicium, du saphir ou MgO, sur un corps de substrat (8), pour la formation d'un substrat composite
- application épitactique d'une pluralité de différentes couches (1) de semi-conducteur aux nitrures de III-V sur la couche intermédiaire (9)
- détachement du corps substrat (8) y compris de la couche intermédiaire (9)
- application du réflecteur (6) sur la deuxième surface principale (4) du corps semi-conducteur,
procédé dans lequel
- le coefficient de dilatation thermique du corps substrat est supérieur au coefficient de dilatation thermique des couches de nitrures de III-V,
- une couche d'adhérence est formée entre corps substrat et couche intermédiaire,
- le corps substrat (8) est au moins vingt fois plus épais que la couche intermédiaire (9), et
- la couche intermédiaire (9) est appliquée par un procédé de collage de plaquettes.

2. Procédé selon la revendication 1,
**caractérisé en ce**
**qu'**on applique comme couche intermédiaire une couche intermédiaire de SiC et on utilise comme corps substrat (8) un substrat de Si.

3. Procédé selon la revendication 1,
**caractérisé en ce**
**qu'**on applique comme couche intermédiaire une couche intermédiaire de SiC.

4. Procédé selon l'une quelconque des revendications 1 à 3,
**caractérisé en ce que**
le réflecteur (6) est formé par application d'une couche métallique qui sert en même temps à l'établissement des contacts du corps semi-conducteur.

5. Procédé selon l'une quelconque des revendications 1 à 4,
**caractérisé en ce que**
pour la production des couches de GaN (1) on applique un masque (11) sur la couche intermédiaire (9).

6. Procédé selon l'une quelconque des revendications 1 à 5,
**caractérisé en ce que**
le corps semi-conducteur est grainé.

7. Procédé selon la revendication 6,
**caractérisé en ce que**
le corps semi-conducteur est grainé par attaque chimique.

8. Procédé selon la revendication 6,
**caractérisé en ce que**
le corps semi-conducteur est grainé par un procédé au jet de sable.

9. Procédé selon la revendication 1 ou 8,
**caractérisé en ce que**
le corps substrat contient du SiC, du poly-SiC, du saphir, du GaN ou de l'AlN.

10. Procédé selon l'une quelconque des revendications 1 ou 9,
**caractérisé en ce que**
la couche intermédiaire présente au moins dans des zones partielles une surface monocristalline.

11. Procédé selon l'une quelconque des revendications 1 ou 9 à 10,
**caractérisé en ce**
**qu'**on dépose les couches de nitrure de III-V sur une surface de Si(111) ou sur une surface de SiC, monocristalline au moins dans des zones partielles, de la couche intermédiaire.

12. Procédé selon la revendication 1,
**caractérisé en ce que**
la couche d'adhérence contient de l'oxyde de silicium.

13. Procédé selon l'une quelconque des revendications 1 ou 9 à 12,
**caractérisé en ce**
**qu'**avant l'application des couches de nitrure de III-V sur le substrat composite est formée une couche de masque à fenêtres d'épitaxie, la surface d'épitaxie du substrat composite restant non couverte à l'intérieur des fenêtres d'épitaxie.

14. Procédé selon l'une quelconque des revendications 1 ou 9 à 13,
**caractérisé en ce**
**qu'**après l'application sur le substrat composite les couches de nitrure de III-V sont structurées en empilements individuels de couches de semi-conducteur.

15. Procédé selon la revendication 14,
**caractérisé en ce**
**qu'**on poursuit le processus par les étapes :
- application d'un support sur les empilements de couches de semi-conducteur,
- détachement du substrat composite.

16. Procédé selon la revendication 14,
**caractérisé en ce**
**qu'**on poursuit le processus par les étapes :
- application d'un support intermédiaire sur les empilements de couches de semi-conducteur,
- détachement du substrat composite,
- application d'un support sur la face des empilements de couches de semi-conducteur, de laquelle a été détaché le substrat composite,
- détachement du support intermédiaire.

17. Procédé selon l'une quelconque des revendications 1 ou 9 à 15,
**caractérisé en ce que**
la couche de réflecteur est formée par application d'une couche métallique.

18. Procédé selon la revendication 17,
caractérisé en ce la couche métallique contient de l'argent, de l'aluminium ou un alliage d'argent ou d'aluminium.

19. Procédé selon l'une quelconque des revendications 17 et 18,
**caractérisé en ce que**
la couche de réflecteur sert en même temps de couche de contact.

20. Procédé selon l'une quelconque des revendications 1 ou 9 à 16,
**caractérisé en ce que**
la couche de réflecteur est formée par un miroir diélectrique.

21. Procédé selon l'une quelconque des revendications 1 ou 9 à 16,
**caractérisé en ce que**
la couche de réflecteur est formée par application d'une première couche transparente sur l'empilement de couches de semi-conducteur et application d'une deuxième couche réflectrice sur la première couche.

22. Procédé selon l'une quelconque des revendications 14 à 21,
**caractérisé en ce que**
la surface de l'empilement de couches de semi-conducteur est grainée au moins par zones.

23. Procédé selon la revendication 22,
**caractérisé en ce que**
la surface de l'empilement de couches de semi-conducteur est grainée par attaque chimique.

24. Procédé selon la revendication 22,
**caractérisé en ce que**
la surface de l'empilement de couches de semi-conducteur est grainée par un procédé au jet de sable.
